# EUROPÄISCHE PATENTSCHRIFT

(11) **EP 4 222 817 B1**
(45) Veröffentlichungstag und Bekanntmachung des Hinweises auf die Patenterteilung: **18.06.2025**
(21) Anmeldenummer: 21770282.8
(22) Anmeldetag: 21.09.2021
(51) Int. Cl.: H01R 4/18, H01R 4/2404, H01R 4/2495, H01R 12/68, H01R 12/78

(54) **ELEKTRISCHE LEITUNGSVERBINDUNG ZUR ELEKTRISCHEN KONTAKTIERUNG EINER FLÄCHENELEKTRODE**
ELECTRICAL LINE CONNECTION FOR ELECTRICALLY CONTACTING A FLAT ELECTRODE
RACCORDEMENT ÉLECTROCONDUCTEUR DESTINÉ AU CONTACT ÉLECTRIQUE D'UNE ÉLECTRODE PLANE

(30) Priorität: 30.09.2020 EP 20199129
(43) Veröffentlichungstag der Anmeldung: 09.08.2023
(73) Patentinhaber: Saint-Gobain Sekurit France, 60150 Thourotte (FR)
(72) Erfinder: REUL, Bernhard, 52134 Herzogenrath (DE); HERMANGE, Francois, 52074 Aachen (DE); SPANJERS, Robin, 52072 Aachen (DE)
(74) Vertreter: Weber, Sophie
(86) Internationale Anmeldenummer: PCT/EP2021/075909
(87) Internationale Veröffentlichungsnummer: WO 2022/069293

(56) Entgegenhaltungen:
- EP-A2- 1 237 228
- JP-A- 2005 310 570

## Beschreibung

Die Erfindung betrifft ein Substrat mit einem Funktionselement umfassend eine elektrische Leitungsverbindung mit einem Querschnittsübergangsbereich und eine Verbundscheibe mit mindestens einer solchen Leitungsverbindung.

Bei Verbundscheiben, die mindestens zwei starre Scheiben und eine diese flächig verbindende Zwischenschicht sowie elektrische Bauelemente aufweisen, umfassen solche Leitungsverbindungen üblicherweise einen Übergang von einem Flachbandleiter zu einem Kabel. Die in einer Verbundscheibe verbauten Bauelemente können Heizkomponenten, Antennenelemente und flach eingebaute Funktionselemente sein, die über sogenannte Sammelleiter elektrisch kontaktiert werden können. Derart ausgestattete Verbundscheiben finden in Automobilen als Dach-, Windschutz-, Heck- und Seitenscheibe oder auch im Baubereich ihre Anwendung.

Funktionselemente mit elektrisch steuerbaren optischen Eigenschaften werden in der industriellen Produktion von Verbundscheiben als z.B. Dachscheiben eingesetzt. Das Funktionselement ist dabei in der Verbundscheibe eingebettet. Bei der Herstellung der Verbundscheibe wird das Funktionselement in der gewünschten Größe und Form aus einem Funktionselement ausgeschnitten und zwischen die Folien der Zwischenschicht eingelegt. Typische Zwischenschichten sind dabei Polyvinylbutyralfolien, die neben ihren Klebeeigenschaften eine hohe Zähigkeit und eine hohe akustische Dämpfung aufweisen. Die Zwischenschicht verhindert den Zerfall der Verbundscheibe bei einer Beschädigung. Die Verbundscheibe bekommt lediglich Sprünge, bleibt aber formstabil.

Solche Verbundscheiben enthalten ein Funktionselement, welches typischerweise eine aktive Schicht zwischen zwei Flächenelektroden enthält. Die optischen Eigenschaften der aktiven Schicht können durch eine an die Flächenelektroden angelegte Spannung verändert werden. Ein Beispiel hierfür sind elektrochrome Funktionselemente, die beispielsweise aus US 20120026573 A1 bekannt sind. Ein weiteres Beispiel sind SPD-Funktionselemente (Suspended Particle Device) oder PDLC-Funktionselemente (Polymer Dispersed Liquid Crystal), die beispielsweise aus EP 0876608 B1 und WO 2011033313 A1 bekannt sind. Durch eine an den Flächenelektroden angelegte Spannung lässt sich die Transmission von sichtbarem Licht durch elektrochrome oder SPD/PDLC-Funktionselemente steuern.

SPD- und PDLC-Funktionselement sind als Mehrschichtfolien kommerziell erhältlich. Die zum Anlegen einer Spannung erforderlichen Flächenelektroden sind zwischen zwei PET-Trägerfolien angeordnet. Die Flächenelektroden können über Flachleiter außerhalb der Verbundscheibe mit einem Kontrollmodul (ECU) elektrisch leitend verbunden werden. Das Kontrollmodul ist zum Anlegen der elektrischen Spannung zwischen den Flächenelektroden vorgesehen. Um eine flexible Leitungsverbindung als Außenanschluss aus dem Innenraum der Verbundscheibe herauszuführen, verwendet man üblicherweise Flachleitungen, die aus mindestens einem dünnen Trägersubstrat und einer metallischen Leiterbahn (Leiterstreifen) bestehen. Zusätzlich kann eine weitere Deckschicht vorgesehen sein, so dass der Flachleiter insgesamt ein dreilagiges Laminat bildet. Die Flachleiter werden mit Anschlussflächen nahe am Rand der Verbundscheibe verlötet und nur über diesen Rand hinweg nach außen geführt, wo sie mit einem kurzen Abstand zum Rand mit einem Rundkabel verbunden werden.

Die elektrische Kontaktierung ist ein mühsamer Schritt bei der Herstellung einer Verbundscheibe mit einem in mehrere Segmente aufgeteilten Funktionselement, da jedes Segment einzeln elektrisch kontaktiert werden muss. Dies ist üblicherweise durch die Flachleiter realisiert, die über die Sammelleiter (bus bars), beispielsweise Streifen eines elektrisch leitfähigen Materials oder elektrische leitfähige Aufdrucke (beispielsweise ausgebildet durch einen silberhaltigen Siebdruck), mit den Flächenelektroden verbunden sind. Die Kontaktierung erfolgt Schritt für Schritt manuell und umfasst viele Arbeitsschritte. Insbesondere müssen die Leiter der Rundkabel durch manuelles Löten mit den Leiterbahnen des Flachleiters kontaktiert werden. Dieses Vorgehen ist sehr zeitaufwendig und mühsam.

JP 2005 310570 A offenbart eine Anschlussstruktur zum Verbinden eines Flachkabels für einen drehbaren Verbinder.

EP1237228 A2 offenbart einen Relaisverbinder mit einem isolierenden Gehäuse, der mehrere Verbindungsanschlüsse zwischen flachen und runden Leitern aufweist.

Die Aufgabe der vorliegenden Erfindung besteht darin, eine verbesserte elektrische Leitungsverbindung bereitzustellen, welche auf einfache Weise eine elektrische Kontaktierung eines Funktionselements ermöglicht.

Die Aufgabe der vorliegenden Erfindung wird erfindungsgemäß durch ein Substrat mit einem Funktionselement umfassend eine elektrische Leitungsverbindung gemäß dem unabhängigen Anspruch 1 gelöst. Bevorzugte Ausführungen der Erfindung gehen aus den Unteransprüchen hervor.

Die Erfindung umfasst ein Substrat mit einem Funktionselement sowie eine elektrische Leitungsverbindung mit einem Querschnittsübergangsbereich von einem ein Trägersubstrat und mindestens eine Leiterbahn umfassenden Flachleiter zu einem mindestens einen elektrischen Leiter umfassenden Kabel, wobei im Querschnittsübergangsbereich mindestens eine elektrische Verbindung zwischen der mindestens einen Leiterbahn und dem Kabel vorgesehen ist und wobei der Querschnittübergangsbereich eine Steckverbindung zur Herstellung einer elektrischen Verbindung zwischen dem Flachleiter und dem Kabel aufweist. Dabei umfasst die Steckverbindung zwei Verbindungselemente, wobei jeweils eine Leiterbahn des Flachleiters zur Verbindung mit einem Leiter eines Kabels über die Steckverbindung vorgesehen ist.

Wesentlich hierbei ist, dass der Querschnittübergangsbereich mindestens eine Steckverbindung zwischen dem Flachleiter und dem Kabel aufweist, die zur Herstellung der elektrischen Verbindung zwischen dem Flachleiter und dem Kabel vorgesehen sind.

Der Vorteil der erfindungsgemäßen Leitungsverbindung besteht darin, dass durch die Steckverbindung zwischen dem Flachleiter und dem Kabel der Arbeitsaufwand bei der Herstellung von elektrischen Verbindungen reduziert und somit wertvolle Arbeitszeit beim Einbau einer Verbundscheibe gespart wird. Die Steckverbindung kann automatisch zusammengesetzt werden und ist damit für eine industrielle Massenfertigung sehr vorteilhaft. Durch die Verwendung der Steckverbindung kann auf die Verwendung eines Lots verzichtet werden, so dass die Erzeugung von mechanischen Spannungen durch Einbringen von Energie beim Lötvorgang vermieden werden.

Der Querschnittsübergangsbereich kann eine Crimpverbindung (auch Klemmverbindung oder Quetschverbindung genannt) als Fügeverbindung aufweisen. Die Verwendung von Crimpverbindungen ist vor allem hinsichtlich einer kostengünstigen Produktion vorteilhaft. Der Querschnittsübergangsbereich weist mindestens ein, insbesondere um das Kabel, gecrimptes Metallteil auf, welches beim Zusammenfügen des Flachleiters mit dem Kabel so angeordnet ist, dass eine mechanisch stabile Verbindung zwischen dem Flachleiter und dem Kabel entsteht. Die Fügeverbindung innerhalb des Querschnittsübergangsbereich ist somit sicher und zuverlässig, da sie eine Crimpverbindung aufweist.

Der Flachleiter (auch Flachkabel genannt) umfasst mindestens eine auf einem Trägersubstrat aus Kunststoff aufgebrachte elektrische Leiterbahn, die mit einer Deckschicht aus Kunststoff abgedeckt sein kann. Das Trägersubstrat und die Deckschicht formen gemeinsam eine Isolationshülle, welche die elektrische Leiterbahn umhüllt. Der insbesondere flexible und/oder biegsame Flachleiter (z.B. FFC = Flexible Flat Cable) dient zum elektrischen Anschluss an eine Flächenelektrode. Der flexible Flachleiter ist ein flächiger Körper mit zwei gegenüberliegenden Seiten, der wahlweise in eine ebene oder gekrümmte Form gebracht werden kann. Im ebenen (d.h. nicht-gekrümmten) Zustand ist der Flachleiter in einer Ebene angeordnet. Der Flachleiter ist generell länglich ausgebildet und weist entlang seiner Erstreckungsrichtung zwei Enden auf. Der Flachleiter kann auch mit einer Mehrzahl, insbesondere parallel verlaufender, elektrischer Leiterbahnen versehen sein. Vorzugsweise kann der Flachleiter bis zu 32, besonders bevorzugt 8 bis 10, Leiterbahnen aufweisen. Die Leiterbahnen sind in einer gemeinsamen Ebene angeordnet. Jede Leiterbahn kann dabei einen rechteckigen Querschnitt aufweisen. Der Flachleiter ist ein längliches elektrisches Bauteil mit mehreren elektrischen Leiterbahnen, dessen Breite deutlich größer ist als die Dicke. Der Flachleiter ist derart dünn ausgebildet (d.h. die Dicke ist derart gering), dass es flexibel und biegbar ist. Seine Breite kann dabei 0,8 mm bis 100 mm betragen.

Ferner umfasst der Flachleiter mindestens zwei Anschlussbereiche mit Kontaktstellen der Leiterbahnen an zwei in Erstreckungsrichtung gegenüberliegenden Enden des Flachleiters. Die Anschlussbereiche des Flachleiters dienen zum elektrischen Kontaktieren der Leiterbahnen, zu welchem Zweck die Isolationshülle, d.h. Trägerschicht und/oder Deckschicht, zumindest an den Kontaktstellen nicht vorhanden oder entfernt ist, so dass die Leiterbahnen zugänglich sind.

Die elektrischen Leiterbahnen sind zumindest abschnittsweise nebeneinander liegend angeordnet. Jede elektrische Leiterbahn kann an zwei entlang der Leiterbahn voneinander beabstandeten Kontaktstellen elektrisch kontaktiert werden. Die Kontaktstellen sind Bereiche der Leiterbahnen, an denen eine elektrische Kontaktierung möglich ist. In der einfachsten Ausgestaltung handelt es sich hierbei um zugängliche Bereiche der elektrischen Leiterbahnen. Dabei kann es erforderlich und sinnvoll sein, für jeden Pol eine eigene Leitungsverbindung vorzusehen, so dass jeweils eine Leiterbahn des Flachleiters zur Verbindung mit einem Leiter eines Kabels vorgesehen ist.

Die Leiterbahnen werden mittels Druckverfahren aufgebracht. Alternativ werden die elektrischen Leiterbahnen als Metallstreifen aus Metallfolien vorgefertigt und beidseitig mit einem Kunststoffmaterial laminiert. In beiden Fällen sind die elektrischen Leiterbahnen mechanisch stabilisiert und in eine Isolationshülle eingebettet, so dass sie gegen die äußere Umgebung elektrisch isoliert sind.

Solche flexiblen Flachleiter haben an ihren beiden Enden einen Anschlussbereich (Kontaktstellen), der zumindest eine Aussparung der Deckfolie aufweist. Im Querschnittsübergangsbereich weist der Flachleiter eine Aussparung der Deckfolie und Trägersubstrats auf, so dass die Leiterbahn in diesem Bereich keine Isolationshülle umfasst. Der Flachleiter weist ein erstes Verbindungselement, insbesondere einen Steckkontakt als männlichen Teil der Steckverbindung, zur Herstellung der Steckverbindung auf. Ein derartiges Verbindungselement schafft eine einfache und kostengünstige Möglichkeit einer Steckverbindung, die vorzugweise das erste Verbindungselement als einen männlichen Teil und ein zweites Verbindungselement als einen weiblichen Teil aufweist.

Das Kabel weist das zweite Verbindungselement auf, das eine Aufnahme zur Verbindung mit einem ersten Verbindungselement, insbesondere eine Buchse zur Aufnahme eines Steckkontakts, umfasst. Das Kabel kann neben einem elektrisch leitfähigen Leiter (Innenleiter oder auch Seel, Ader oder Kern genannt) einen isolierenden, bevorzugt polymeren Kabelmantel umfassen, wobei der isolierende Kabelmantel bevorzugt im Endbereich des Kabels entfernt ist, um eine elektrisch leitende Verbindung zwischen Leiter des Kabels und einem Verbindungselement zu ermöglichen. Der elektrisch leitfähige Leiter des Kabels kann beispielsweise Kupfer, Aluminium und/oder Silber oder Legierungen oder Gemische davon enthalten. Das Kabel weist eine vorzugsweise runde oder ovalen Querschnitt auf, der beispielsweise 0,3 mm² bis 6 mm² beträgt.

Der Querschnittübergangsbereich kann durch eine Kunststoff aufweisende Ummantelung geschützt sein. Dadurch, dass die Ummantelung elektrisch isolierend ausgebildet ist, wird das Risiko von Kurzschlüssen minimiert. Die Ummantelung kann als ein rechteckiges Gehäuse ausgebildet sein, die bei Bedarf im Querschnittübergangsbereich auch mehrere parallele Leitungen umhüllen kann.

Die Erfindung betrifft ferner eine Verbundscheibe, umfassend das erfindungsgemäße Substrat. Das Substrat ist als eine erste Scheibe ausgebildet, wobei die Verbundscheibe eine zweite Scheibe sowie zwei Zwischenschichten zwischen der ersten Scheibe und der zweiten Scheibe aufweist. Das Funktionselement ist zwischen den beiden Zwischenschichten angeordnet, wobei der Flachleiter an einem Ende mit einer Flächenelektrode des Funktionselements elektrisch leitend verbunden ist.

Das Funktionselement weist elektrisch steuerbare optische Eigenschaften auf und umfasst flächenmäßig übereinander angeordnet eine erste Trägerfolie, eine erste Flächenelektrode, eine aktive Schicht, eine zweite Flächenelektrode und eine zweite Trägerfolie. Gemäß einer Ausgestaltung des erfindungsgemäßen Verbundscheibe ist das Funktionselement ein sogenanntes PDLC (Polymer Dispersed Liquid Crystal) - Funktionselement.

Die aktive Schicht weist die veränderlichen optischen Eigenschaften auf, die durch eine an die aktive Schicht angelegte elektrische Spannung gesteuert werden können. Unter elektrisch steuerbaren optischen Eigenschaften werden im Sinne der Erfindung solche Eigenschaften verstanden, die stufenlos steuerbar sind, aber gleichermaßen auch solche, die zwischen zwei oder mehr diskreten Zuständen geschaltet werden können. Die optischen Eigenschaften betreffen insbesondere die Lichttransmission und/oder das Streuverhalten.

Bei der ersten und zweiten Trägerfolie handelt es sich insbesondere um polymere oder thermoplastische Folien. Die Trägerfolien enthalten insbesondere ein thermoplastisches Material oder bestehen daraus. Das thermoplastische Material kann ein thermoplastisches Polymer oder eine Mischung von zwei oder mehr thermoplastischen Polymeren sein. Neben dem thermoplastischen Material kann die Trägerfolie ferner Zusätze enthalten, wie z.B. Weichmacher. Das thermoplastische Material der Trägerfolien ist bevorzugt Polyethylenterephthalat (PET), wie es bei kommerziell erhältlichen Funktionselementen üblich ist.

Das thermoplastische Material der Trägerfolie kann auch Mischungen von PET mit anderen thermoplastischen Polymeren und/oder Copolymere von PET enthalten oder daraus bestehen. Das thermoplastische Material der Trägerfolie kann z.B. auch PU, Polypropylen, Polycarbonat, Polymethylmethacrylat, Polyacrylat, Polyvinylchlorid, Polyacetatharz, fluorinierte Ethylen-Propylene, Polyvinylfluorid und/oder Ethylen-Tetrafluorethylen enthalten oder daraus bestehen. Die Dicke jeder Trägerfolie liegt bevorzugt im Bereich von 0,03 mm bis 0,4 mm, bevorzugter von 0,04 mm bis 0,2 mm.

Die Flächenelektroden des Funktionselements umfassen eine elektrisch leitfähigen Beschichtung auf der Trägerfolie. Die Seite der Trägerfolie mit der die Flächenelektrode bildenden elektrisch leitfähigen Beschichtung ist dann der aktiven Schicht zugewandt.

In einer weiteren vorteilhaften Ausführungsform kann das Funktionselement durch Isolierungslinien in Segmente aufgeteilt sein. Die Isolierungslinien sind insbesondere in die Flächenelektroden eingebracht, so dass die Segmente der Flächenelektrode elektrisch voneinander isoliert sind. Die einzelnen Segmente sind unabhängig voneinander über einen Anschlussbereich und dem Flachleiter mit einer externen Spannungsquelle verbindbar, so dass sie im Betriebszustand separat angesteuert werden können. Dabei weist ein Segment des Funktionselements zwei Anschlussbereiche auf. Jeder Anschlussbereich weist eine Kontaktierung auf. So können beispielsweise verschiedene Bereiche des Funktionselements, z.B. als Sonnenblende, unabhängig geschaltet werden.

In einer weiteren bevorzugten Ausgestaltung ist das Funktionselement ein PNLC- oder SPD-Funktionselement. Bei SPD- Funktionselement enthält die aktive Schicht suspendierte Partikel, wobei die Absorption von Licht durch die aktive Schicht mittels Anlegen einer Spannung an die Flächenelektroden veränderbar ist. PNLC-Funktionselemente (PNLC = polymer network liquid crystal) enthalten eine aktive Schicht, bei der die Flüssigkristalle in ein Polymernetzwerk eingelagert sind, wobei die Funktionsweise ansonsten analog wie bei den PDLC-Funktionselementen ist.

Die Flächenelektroden sind dazu vorgesehen mit einer externen Spannungsquelle elektrisch verbunden zu werden. Die Kontaktierung der Flächenelektrode erfolgt bevorzugt mit (Ultraschall-) Löten, Vercrimpen oder Verkleben. Dazu wird auf mindestens eine der Flächenelektroden ein leitfähiges Material, insbesondere eine Paste, oder ein Lötkontakt aufgebracht. Die Paste enthält Silber oder eine silberhaltige Legierung. Das leitfähige Material wird als sogenannte Sammelleiter (bus bars), beispielsweise Streifen des elektrisch leitfähigen Materials oder elektrisch leitfähige Aufdrucke, mit den Flächenelektroden verbunden. Die Flächenelektroden können mittels jeweils eines Sammelleiters elektrisch kontaktiert werden.

In einer alternativen Ausgestaltung der Sammelleiter werden dünne und schmale Metallfolienstreifen oder Metalldrähte verwendet, die bevorzugt Kupfer und/oder Aluminium enthalten, insbesondere werden Kupferfolienstreifen mit einer Dicke von etwa 50 µm verwendet. Die Breite der Kupferfolienstreifen beträgt bevorzugt 1 mm bis 10 mm. Die Metallfolienstreifen oder Metalldrähte werden bei einer weiteren Verarbeitung des Funktionselements in einem Verbund aus thermoplastischen Schichten auf die Flächenelektrode aufgelegt. Im späteren Autoklavprozess wird durch Einwirkung von Wärme und Druck ein sicherer elektrischer Kontakt zwischen den Sammelleitern und der Beschichtung erreicht. Der elektrische Kontakt zwischen Flächenelektrode und Sammelleiter kann alternativ durch Auflöten oder Kleben mit einem elektrisch leitfähigen Kleber hergestellt werden.

Die Sammelleiter werden an die Flächenelektroden angebracht, indem die Trägerfolie, eine Flächenelektrode und die aktive Schicht ausgespart sind, so dass die jeweils andere Flächenelektrode mit der dazugehörigen Trägerfolie übersteht. Dies kann bevorzugt entlang eines Randbereichs der jeweiligen Seite des Funktionselements durchgeführt werden. Auf der überstehenden Flächenelektrode kann dann ein Sammelleiter angebracht werden oder der Flachleiter direkt mit der Flächenelektrode kontaktiert werden. Auf der gegenüberliegenden Seite des jeweiligen Funktionselements ist ein weiterer Sammelleiter in entsprechender Weise an die andere Flächenelektrode angebracht.

In einer vorteilhaften Ausgestaltung ist das Funktionselement ein PDLC-Funktionselement, insbesondere ein solches, das mindestens einen Bereich der Verbundscheibe oder einer Verglasungseinheit von einem transparenten in einen opaken Zustand und umgekehrt schaltet. Die aktive Schicht eines PDLC-Funktionselements enthält Flüssigkristalle, welche in eine Polymermatrix eingelagert sind. Die Dicke des Funktionselements beträgt beispielsweise von 0,09 mm bis 1 mm.

Im Folgenden wird die Erfindung anhand von Figuren und Ausführungsbeispielen näher erläutert. Die Figuren sind eine schematische Darstellung und nicht maßstabsgetreu. Die Figuren schränken die Erfindung in keiner Weise ein.

Es zeigen:
- Figur 1: eine schematische Darstellung eines Flachleiters,
- Figur 2: eine schematische Darstellung eines Kabels,
- Figur 3: eine Ausführungsform einer erfindungsgemäßen Leitungsverbindung, und
- Figur 4: eine Darstellung der erfindungsgemäßen Leitungsverbindung mit einer Ummantelung,
- Figur 5: eine zweite Ausführungsform des Flachleiters, und
- Figur 6: eine zweite Ausführungsform des Kabels.

Nachfolgend wird die Erfindung eingehender unter Bezugnahme auf die Figuren dargestellt. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden soweit nicht explizit als reine Alternative dargestellt.

Angaben mit Zahlenwerten sind in aller Regel nicht als exakte Werte zu verstehen, sondern beinhalten auch eine Toleranz von +/- 1 % bis zu +/- 10 %.

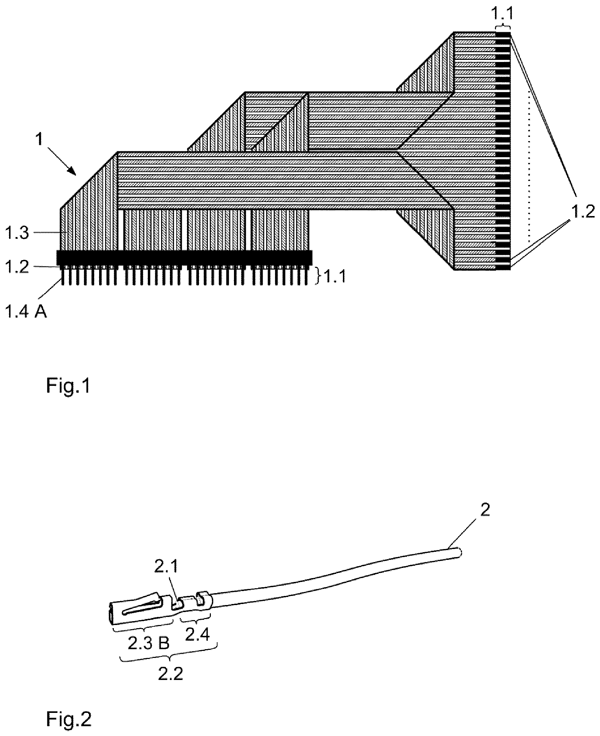

Figur 1 zeigt einen Flachleiter 1, der über 32 parallel verlaufende Leiterbahnen 1.2 verfügt. Die Leiterbahnen 1.2 sind gleichmäßig zueinander beabstandet und weisen jeweils einen rechteckigen Querschnitt auf. Die Leiterbahnen 1.2 werden von einer aus einer Trägerschicht und Deckfolie bestehenden Isolationshülle 1.3 umhüllt. An seinen zwei in Erstreckungsrichtung gegenüberliegenden Enden weist der Flachleiter 1 jeweils mehrere Anschlussbereiche 1.1 mit Kontaktstellen der Leiterbahnen 1.2 auf. Die Anschlussbereiche 1.1 des Flachleiters 1 dienen zum elektrischen Kontaktieren der Leiterbahnen 1.2. Die Isolationshülle 1.3 ist an den Kontaktstellen zumindest teilweise entfernt, so dass die Leiterbahnen 1.2 zugänglich sind.

Die elektrischen Leiterbahnen 1.2 sind nebeneinander liegend angeordnet. Jede elektrische Leiterbahn 1.2 ist an zwei entlang der Leiterbahn 1.2 voneinander beabstandeten Anschlussbereichen 1.1 elektrisch kontaktierbar. Eine Leiterbahn 1.2 ist jeweils zur Verbindung mit einem Leiter (2.1) eines Kabels 2 vorgesehen.

Solche flexiblen Flachleiter 1 haben eine Kontaktierungsseite, welche der Seite der Deckschicht entspricht, die in einem Querschnittsübergangsbereich 11 eine Aussparung aufweist. Der Flachleiter 1 weist einen Steckkontakt, d.h. einen männlichen Teil, als ein erstes Verbindungselement 1.4 A auf. Der Steckkontakt ist zur Herstellung einer Steckverbindung vorgesehen.

Figur 2 zeigt eine Draufsicht auf eine Ausgestaltung eines Kabels 2. Das Kabel 2 umfasst neben einem elektrisch leitfähigen Leiter 2.1 auch einen isolierende, polymeren Kabelmantel, wobei der isolierende Kabelmantel im Endbereich des Kabels entfernt ist, um eine elektrisch leitende Verbindung zwischen dem Leiter 2.1 des Kabels 2 und einem zweitem Verbindungselement 2.2 zu ermöglichen. Der elektrisch leitfähige Leiter 2.1 des Kabels 2 enthält Kupfer. Das Kabel 2 weist eine runden Querschnitt auf, der beispielsweise 5 mm² beträgt.

Das Kabel 2 kann prinzipiell jedes Anschlusskabel sein, das dem Fachmann zur elektrischen Kontaktierung eines Funktionselements bekannt ist und dazu geeignet ist, durch Crimpen bzw. Festklemmen mit einem Verbindungselement (auch Crimpkontakt genannt) verbunden zu werden. Der Leiter 2.1 (auch als Seele oder Kern bezeichnet) des Kabels 2 ist an dessen zum Flachleiter 1 hinweisenden Ende abisoliert und weist das zweite Verbindungselement 2.2 auf. Das zweite Verbindungselement 2.2 ist im Endbereich des Kabels 2 um den Leiter 2.1 des Kabels 2 gecrimpt, so dass eine dauerhafte stabile elektrisch leitfähige Verbindung zwischen dem zweiten Verbindungselement 2.2 und Kabel 2 entsteht. Das Crimpen erfolgt mit einem geeigneten, dem Fachmann an sich bekannten Crimpwerkzeug, beispielsweise einer Crimpzange oder einer Crimppresse. Das Crimpwerkzeug umfasst üblicherweise zwei Wirkstellen, beispielsweise die Backen einer Crimpzange, welche gegeneinander geführt werden, wodurch ein mechanischer Druck auf das zweite Verbindungselement 2.2 ausgeübt wird. Das zweite Verbindungselement 2.2 wird dadurch plastisch verformt und um das Kabel 2 gequetscht.

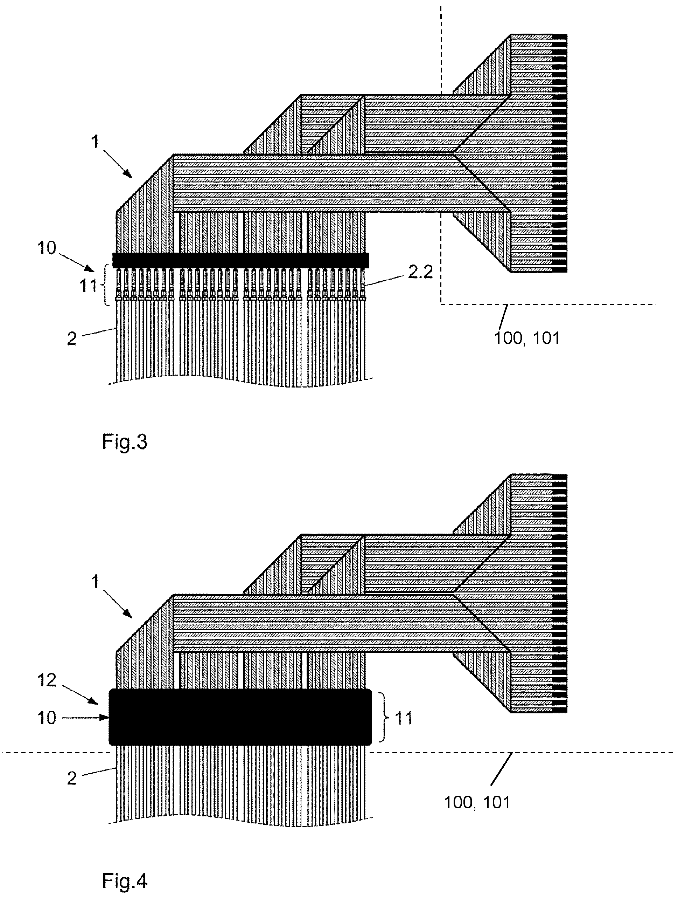

Das zweites Verbindungselement 2.2 umfasst eine Buchse 2.3 B, d.h. einen weiblichen Teil, zur Aufnahme des Steckkontakts 1.4 A und einen um das Kabel 2 gecrimpten Bereich 2.4 (dem sogenannten Crimp, also dem durch den Crimpvorgang verformten Bereich) auf, so dass das zweite Verbindungselement 2.2 durch Crimpen mit dem Kabel 2 verbunden ist. Die Crimpverbindung ist einfach, kostengünstig und leicht automatisierbar. Aufwendige zusätzliche Prozessschritte beispielsweise das Verlöten oder Verschweißen des Verbindungselements 2.2 mit dem Kabel 2 können somit vermieden werden. Die Buchse 2.3 B ist an derjenigen Seite des gecrimpten Bereichs 2.4 angeordnet, die der Erstreckungsrichtung des Kabels 2 zu einer Steuereinheit (hier nicht dargestellt) gegenüberliegt. Das Kabel 2 ist dafür vorgesehen, das Funktionselement mit der Steuereinheit, beispielsweise einer Spannungsversorgung, über den Flachleiter 1 elektrisch zu verbinden. Dazu ist das Kabel 2 ausgehend vom Flachleiter 1 bevorzugt über einer Seitenkante eines Substrats 100 oder einer Verbundscheibe 101 (in Figur 3 und 4 dargestellt) hinweg von dem Substrat 100 oder der Verbundscheibe 101 weggeführt.

Figur 3 zeigt eine Ausführungsform einer erfindungsgemäßen Leitungsverbindung 10 mit einem Querschnittübergangsbereich 11. Die Leitungsverbindung 10 umfasst das Kabel 2 mit dem zweitem Verbindungselement 2.2 und den Flachleiter 1 mit dem ersten Verbindungselement 1.4 A. Weiterhin umfasst die Leitungsverbindung 10 eine Steckverbindung zwischen ersten Verbindungselement 1.4 und dem zweiten Verbindungselement 2.2. Das erste Verbindungselement 1.4 kann als Steckkontakt (männliches Teil) mit der Buchse 2.3 B (weibliches Teil) eine elektrische Steckverbindung formen. Jeweils eine Leiterbahn 1.2 des Flachleiters 1 ist an dessen zum runden Kabel 2 hinweisenden Ende abisoliert. Das erste Verbindungselement 1.4 A (Steckkontakt) kann in die Buchse 2.3 B geschoben werden. Das erste Verbindungselement 1.4 A (Steckkontakt) stellt dann in der in Figur 3 dargestellten Endstellung einen elektrischen Kontakt zwischen der Buchse 2.3 B und der Leiterbahn 1.2 her. Jeweils ein erstes Verbindungselement 1.4 A ist als Steckkontakt in jeweils einer Buchse 2.3 B eingesteckt.

Figur 4 zeigt eine Ausführungsform der Leitungsverbindung 10 mit einer Ummantelung 12.

Der Querschnittübergangsbereich 11 kann durch eine Kunststoff aufweisende Ummantelung 12 geschützt sein. Dadurch, dass die Ummantelung 12 elektrisch isolierend ausgebildet ist, wird das Risiko von Kurzschlüssen minimiert. Die Ummantelung 12 ist als ein rechteckiges Gehäuse ausgebildet, das im Querschnittübergangsbereich 11 mehrere parallele Leitungsverbindungen 10 umhüllen kann.

Die erfindungsgemäße Leitungsverbindung 10 mit dem Querschnittübergangsbereich 11 kann einfach und kostengünstig hergestellt werden und erlaubt eine platzsparende, flexibel einsetzbare und dauerhaft stabile elektrische Kontaktierung eines in einer Verbundscheibe 101 angeordneten Funktionselements.

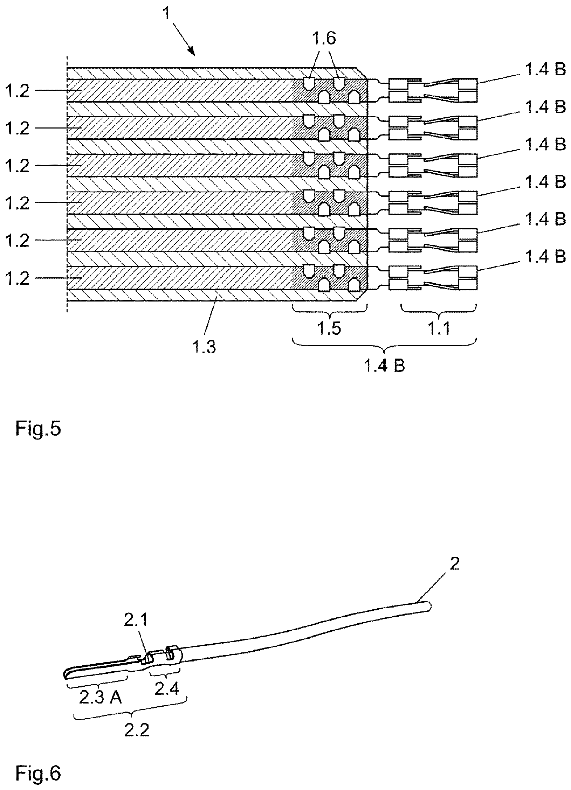

Figur 5 zeigt eine zweite Ausführungsform des Flachleiters 1. Im Unterschied zu Figur 1 verfügt der Flachleiter 1 über ein erstes Verbindungselement 1.4 B in Form einer Buchse als Anschlussbereich 1.1. Das erste Verbindungselement 1.4 B (Buchse) ist zur Aufnahme eines zweiten Verbindungselement 2.3 A in Form eines Steckkontakts vorgesehen. Das erste Verbindungselement 1.4 B ist im Endbereich des Flachleiters 1 um jeweils eine Leiterbahn 1.2 mittels einer Crimplasche 1.6 gecrimpt, so dass eine dauerhafte stabile elektrisch leitfähige Verbindung zwischen dem ersten Verbindungselement 1.4 B und Flachleiter 1 entsteht.

Figur 6 zeigt eine zweite Ausführungsform eines Kabels 2. Im Unterschied zu Figur 2 verfügt das Kabel 2 in Figur 6 über das zweites Verbindungselement 2.2 in Form eines Steckkontakts.

Das Kabel 2 umfasst weiterhin einen elektrisch leitfähigen Leiter 2.1 und einen isolierenden Kabelmantel, der im Endbereich des Kabels 2 entfernt ist. Das zum Flachleiter 1 hinweisenden Ende des Kabels 2 weist den abisolierten Leiter 2.1 auf. Das zweites Verbindungselement 2.2 umfasst den Steckkontakt 2.3 A, d.h. einen männlichen Teil, und einen um das Kabel 2 gecrimpten Bereich 2.4, wobei das zweite Verbindungselement 2.2 durch Crimpen mit dem Kabel 2 verbunden ist. Das zweite Verbindungselement 2.2 ist dazu vorgesehen eine elektrisch leitende Verbindung zwischen dem Leiter 2.1 des Kabels 2 und dem ersten Verbindungselement 1.4 B zu ermöglichen. Der Flachleiters 1 weist dazu das erste Verbindungselement 1.4 B in Form einer passenden Buchse auf.

### Bezugszeichenliste:

- 1: Flachleiter
- 1.1: Anschlussbereich
- 1.2: Leiterbahn
- 1.3: Isolationshülle
- 1.4 A: erstes Verbindungselement (Steckkontakt),
- 1.4 B: erstes Verbindungselement (Buchse)
- 1.5: gecrimpter Bereich (Flachleiter)
- 1.6: Crimplasche
- 2: Kabel
- 2.1: Leiter des Kabels
- 2.2: zweites Verbindungselement
- 2.3 A: zweites Verbindungselement (Steckkontakt)
- 2.3 B: Buchse
- 2.4: gecrimpter Bereich

- 10: Leitungsverbindung
- 11: Querschnittübergangsbereich
- 12: Ummantelung
- 100: Substrat
- 101: Verbundscheibe

## Patentansprüche

1. Verbundscheibe (101) umfassend ein Substrat (100) mit einem Funktionselement,
• wobei das Substrat eine elektrische Leitungsverbindung (10) mit einem Querschnittsübergangsbereich (11) von einem ein Trägersubstrat und mindestens eine Leiterbahn (1.2) umfassenden Flachleiter (1) zu einem mindestens einen elektrischen Leiter (2.1) umfassenden Kabel (2) umfasst,
• wobei im Querschnittsübergangsbereich (11) mindestens eine elektrische Verbindung zwischen der mindestens einen Leiterbahn (1.2) und dem Kabel (2) vorgesehen ist,
• wobei der Querschnittsübergangsbereich (11) eine Steckverbindung zur Herstellung einer elektrischen Verbindung zwischen dem Flachleiter (1) und dem Kabel (2) aufweist,
• wobei die Steckverbindung zwei Verbindungselemente (1.4 A, 1.4 B, 2.2, 2.3 A, 2.3B, 2.4) umfasst,
• wobei jeweils eine Leiterbahn (1.2) des Flachleiters (1) zur Verbindung mit einem Leiter (2.1) eines Kabels (2) über die Steckverbindung vorgesehen ist, **dadurch gekennzeichnet, dass**
• das Kabel (2) ein zweites Verbindungselement (2.2, 2.3 A, 2.3B, 2.4) aufweist, das insbesondere eine Aufnahme zur Verbindung mit einem ersten Verbindungselement (1.4 A, 1.4 B) in Form einer Buchse (2.3 B) oder einen Steckkontakt (2.3 A) aufweist, und **dass** das Substrat (100) als eine erste Scheibe ausgebildet ist und die Verbundscheibe (101) eine zweite Scheibe sowie zwei Zwischenschichten zwischen der ersten Scheibe und der zweiten Scheibe aufweist, wobei das Funktionselement zwischen den beiden Zwischenschichten angeordnet ist und der Flachleiter (1) an einem Ende mit mindestens einer Flächenelektrode des Funktionselements elektrisch leitend verbunden ist und mit einem anderen Ende über das Kabel (2) zur Verbindung mit einer Versorgungsspannung eines Fahrzeugs vorgesehen ist.

2. Verbundscheibe (101) nach Anspruch 1, wobei eine Fügeverbindung zur Verbindung eines der beiden Verbindungselement (1.4 A, 1.4 B, 2.2, 2.3 A, 2.3B, 2.4) am Kabel (1) oder am Flachleiter (1) vorgesehen ist.

3. Verbundscheibe (101) nach Anspruch 2, wobei die Fügeverbindung eine Crimpt-Verbindung, insbesondere einen gecrimpten Bereich (1.5, 2.4) aufweist.

4. Verbundscheibe (101) nach einem der vorgehenden Ansprüche 1 bis 3, wobei der Flachleiter (1) eine Deckfolie zur elektrischen Isolierung der mindestens einen Leiterbahn (1.2) aufweist, die im Querschnittsübergangsbereich (11) eine Aussparung aufweist.

5. Verbundscheibe (101) nach einem der vorhergehenden Ansprüche 1 bis 4, wobei der Flachleiter (1) ein erstes Verbindungselement (1.4 A, 1.4 B), insbesondere einen Steckkontakt (1.4 A) oder eine Buchse (1.4 B), zur Herstellung der Steckverbindung aufweist.

6. Verbundscheibe (101) nach einem der vorhergehenden Ansprüche 1 bis 5, wobei der Flachleiter (1) mehrere parallel verlaufende, insbesondere 1 bis 32, bevorzugt 8 bis 10, Leiterbahnen (1.2) aufweist.

7. Verbundscheibe (101) nach einem der vorhergehenden Ansprüche 1 bis 6, wobei der Querschnittsübergangsbereich (11) eine Kunststoff aufweisende Ummantelung (12) zur elektrischen Isolierung aufweist.

8. Verbundscheibe (101) nach Anspruch 7, wobei die Ummantelung (12) als ein rechteckiges Gehäuse ausgebildet ist.

9. Verbundscheibe (101) nach einem der vorhergehenden Ansprüche 1 bis 8, wobei das Funktionselements elektrisch steuerbare optische Eigenschaften aufweist und flächenmäßig übereinander angeordnet:
- eine erste Trägerfolie,
- eine erste Flächenelektrode,
- eine aktive Schicht,
- eine zweite Flächenelektrode und
- eine zweite Trägerfolie,
umfasst, wobei das Funktionselement ein PDLC-Funktionselement ist.

10. Verbundscheibe (101) nach einem der vorhergehenden Ansprüche 7 bis 9, wobei die Ummantelung (12) als ein rechteckiges Gehäuse ausgebildet ist, das im Querschnittübergangsbereich (11) mehrere parallele Leitungsverbindungen (10) umhüllt.

11. Verbundscheibe (101) nach einem der vorhergehenden Ansprüche 1 bis 10, wobei die Leiterbahnen (1.2) gleichmäßig zueinander beabstandet sind und jeweils einen rechteckigen Querschnitt aufweisen.

## Claims

1. Laminated pane (101) comprising a substrate (100) having a functional element,
• the substrate comprising an electrical line connection (10) having a cross-sectional transition region (11) from a flat conductor (1) comprising a carrier substrate and at least one conductor track (1.2) to a cable (2) comprising at least one electrical conductor (2.1),
• at least one electrical connection being provided between the at least one conductor track (1.2) and the cable (2) in the cross-sectional transition region (11),
• the cross-sectional transition region (11) having a plug connection for establishing an electrical connection between the flat conductor (1) and the cable (2),
• the plug connection comprising two connecting elements (1.4 A, 1.4 B, 2.2, 2.3 A, 2.3B, 2.4),
• a conductor track (1.2) of the flat conductor (1) being provided for connection to a conductor (2.1) of a cable (2) via the plug connection,
**characterized in that**
• the cable (2) has a second connecting element (2.2, 2.3 A, 2.3B, 2.4), which in particular has a receptacle for connection to a first connecting element (1.4 A, 1.4 B) in the form of a socket (2.3 B) or a plug contact (2.3 A), and
**in that** the substrate (100) is designed as a first pane and the laminated pane (101) has a second pane and two intermediate layers between the first pane and the second pane, the functional element being arranged between the two intermediate layers and the flat conductor (1) being electrically conductively connected at one end to at least one planar electrode of the functional element and being provided with another end via the cable (2) for connection to a supply voltage of a vehicle.

2. Laminated pane (101) according to claim 1, wherein a joining connection is provided for connecting one of the two connecting elements (1.4 A, 1.4 B, 2.2, 2.3 A, 2.3B, 2.4) to the cable (1) or to the flat conductor (1).

3. Laminated pane (101) according to claim 2, wherein the joining connection has a crimped connection, in particular a crimped region (1.5, 2.4).

4. Laminated pane (101) according to any of the preceding claims 1 to 3, wherein the flat conductor (1) has a cover film for electrically insulating the at least one conductor track (1.2), which has a recess in the cross-sectional transition region (11).

5. Laminated pane (101) according to any of the preceding claims 1 to 4, wherein the flat conductor (1) has a first connecting element (1.4 A, 1.4 B), in particular a plug contact (1.4 A) or a socket (1.4 B), for establishing the plug connection.

6. Laminated pane (101) according to any of the preceding claims 1 to 5, wherein the flat conductor (1) has a plurality of parallel, in particular 1 to 32, preferably 8 to 10, conductor tracks (1.2).

7. Laminated pane (101) according to any of the preceding claims 1 to 6, wherein the cross-sectional transition region (11) has a plastics material sheath (12) for electrical insulation.

8. Laminated pane (101) according to claim 7, wherein the sheath (12) is designed as a rectangular housing.

9. Laminated pane (101) according to any of the preceding claims 1 to 8, wherein the functional element has electrically controllable optical properties and comprises, arranged one above the other in terms of area:
- a first carrier film,
- a first planar electrode,
- an active layer,
- a second planar electrode and
- a second carrier film,
wherein the functional element is a PDLC functional element.

10. Laminated pane (101) according to any of the preceding claims 7 to 9, wherein the sheath (12) is designed as a rectangular housing which encloses a plurality of parallel line connections (10) in the cross-sectional transition region (11).

11. Laminated pane (101) according to any of the preceding claims 1 to 10, wherein the conductor tracks (1.2) are evenly spaced from one another and each have a rectangular cross-section.

## Revendications

1. Vitrage feuilleté (101) comprenant un substrat (100) comportant un élément fonctionnel,
• dans lequel le substrat comprend une connexion câblée (10) électrique, comportant une zone de transition de section transversale (11) d'un conducteur plat (1) comprenant un substrat de support et au moins une piste conductrice (1.2), à un câble (2) comprenant au moins un conducteur (2.1) électrique,
• dans lequel au moins une connexion électrique est prévue dans la zone de transition de section transversale (11) entre l'au moins une piste conductrice (1.2) et le câble (2),
• dans lequel la zone de transition de section transversale (11) présente une connexion à fiche permettant d'établir une connexion électrique entre le conducteur plat (1) et le câble (2),
• dans lequel la connexion à fiche comprend deux éléments de connexion (1.4 A, 1.4 B, 2.2, 2.3 A, 2.3 B, 2.4),
• dans lequel respectivement une piste conductrice (1.2) du conducteur plat (1) est prévue pour la connexion à un conducteur (2.1) d'un câble (2) par l'intermédiaire de la connexion à fiche,
**caractérisé en ce que**
• le câble (2) présente un second élément de connexion (2.2, 2.3 A, 2.3 B, 2.4) présentant en particulier un logement permettant la connexion à un premier élément de connexion (1.4 A, 1.4 B) sous forme de douille (2.3 B) ou d'un contact à fiche (2.3 A), et
**en ce que** le substrat (100) est réalisé sous forme de première vitre et le vitrage feuilleté (101) présente une seconde vitre ainsi que deux couches intermédiaires entre la première vitre et la seconde vitre, dans lequel l'élément fonctionnel est disposé entre les deux couches intermédiaires et le conducteur plat (1) est connecté de manière électriquement conductrice, au niveau d'une extrémité, à au moins une électrode de surface de l'élément fonctionnel et est pourvu d'une autre extrémité par l'intermédiaire du câble (2) pour la connexion à une tension d'alimentation d'un véhicule.

2. Vitrage feuilleté (101) selon la revendication 1, dans lequel une connexion d'assemblage est prévue pour connecter l'un des deux éléments de connexion (1.4 A, 1.4 B, 2.2, 2.3 A, 2.3B, 2.4) au câble (1) ou au conducteur plat (1).

3. Vitrage feuilleté (101) selon la revendication 2, dans lequel la connexion d'assemblage présente une connexion sertie, en particulier une zone sertie (1.5, 2.4).

4. Vitrage feuilleté (101) selon l'une des revendications précédentes 1 à 3, dans lequel le conducteur plat (1) présente un film de recouvrement pour l'isolation électrique de l'au moins une piste conductrice (1.2), lequel film présente un évidement dans la zone de transition de section transversale (11).

5. Vitrage feuilleté (101) selon l'une des revendications précédentes 1 à 4, dans lequel le conducteur plat (1) présente un premier élément de connexion (1.4 A, 1.4 B), en particulier un contact à fiche (1.4 A) ou une douille (1.4 B), permettant d'établir la connexion à fiche.

6. Vitrage feuilleté (101) selon l'une des revendications précédentes 1 à 5, dans lequel le conducteur plat (1) présente plusieurs, en particulier 1 à 32, de préférence 8 à 10, pistes conductrices (1.2) s'étendant parallèlement.

7. Vitrage feuilleté (101) selon l'une des revendications précédentes 1 à 6, dans lequel la zone de transition de section transversale (11) présente un enrobage (12) présentant une matière plastique pour l'isolation électrique.

8. Vitrage feuilleté (101) selon la revendication 7, dans lequel l'enrobage (12) est réalisé sous forme de boîtier rectangulaire.

9. Vitrage feuilleté (101) selon l'une des revendications précédentes 1 à 8, dans lequel l'élément fonctionnel présente des propriétés optiques pouvant être commandées électriquement et comprend, superposés en surface :
- un premier film de support,
- une première électrode de surface,
- une couche active,
- une seconde électrode de surface, et
- un second film de support,
dans lequel l'élément fonctionnel est un élément fonctionnel PDLC.

10. Vitrage feuilleté (101) selon l'une des revendications précédentes 7 à 9, dans lequel l'enrobage (12) est réalisé sous forme de boîtier rectangulaire enveloppant plusieurs connexions câblées (10) parallèles dans la zone de transition de section transversale (11).

11. Vitrage feuilleté (101) selon l'une des revendications précédentes 1 à 10, dans lequel les pistes conductrices (1.2) sont régulièrement espacées les unes des autres et présentent respectivement une section transversale rectangulaire.
